# EUROPEAN PATENT APPLICATION

(11) **EP 1 837 988 A1**
(43) Date of publication of application: **26.09.2007**
(21) Application number: 06005891.4
(22) Date of filing: 22.03.2006
(51) Int. Cl.: H03D 7/16

(54) **Joint DRM AM simulcast encoder and transmitter equalizer**

(71) Applicant: SONY DEUTSCHLAND GMBH, 10785 Berlin (DE)
(72) Inventor: Wildhagen, Jens, Hedelfinger Strasse 61, 70327 Stuttgart (DE); Schill, Dietmar, Hedelfinger Strasse 61, 70327 Stuttgart (DE)
(74) Representative: Müller - Hoffmann & Partner

(57) **Abstract**

The present invention relates to a signal estimation apparatus, a signal deviation estimation apparatus, a signal pre-transmission preparation apparatus and a simulcast broadcasting system as well as corresponding methods and a corresponding computer program product. In particular, the present invention relates to the above, wherein a predetermined non-linearity, *e.g.* for modelling a transmission of a broadcast signal, is applied to a signal so as to obtain an estimation signal *e.g.* of a transmitted broadcast signal.

## Description

### BACKGROUND OF THE INVENTION

### Field of the invention

The present invention relates to a signal estimation apparatus, a signal deviation estimation apparatus, a signal pre-transmission preparation apparatus and a simulcast broadcasting system as well as corresponding methods and a corresponding computer program product. In particular, the present invention relates to the above, wherein a predetermined non-linearity, *e.g.* for modelling a transmission of a broadcast signal, is applied to a signal so as to obtain an estimation signal *e.g*. of a transmitted broadcast signal.

### Description of the related prior art

European patent application EP 1 276 257 A1, the contents of which are incorporated herein by reference, discloses an AM simulcast broadcast signal that combines a digital transmission signal and an analog transmission signal in one transmission channel.

The inventors of the present invention have discovered that implementation of the teachings of the aforementioned European patent applications in an encoding device significantly increases the computational complexity of the device. Moreover, they have discovered that independent solution of the problems posed therein requires high computational power and may result in a larger residual distortion of the resultant output signal as compared to a joint solution.

It is consequently an object of the present invention to solve the problems posed in the aforementioned European patent applications while minimizing complexity and required processing power.

Further objects of the invention include implementing simulcast of an analog and a digital signal without crosstalk therebetween, implementing transmitter equalization resulting in low in-band and out-of-band distortion, effecting low overall residual distortion and accommodating any non-linearity of the transmitter model.

### SUMMARY OF THE INVENTION

In its broadest aspect, the invention constitutes a method for signal estimation and comprises the step of applying a predetermined non-linearity to a mixed signal comprising a modulated analog signal and a modulated digital signal. Naturally, the invention can likewise be seen in a corresponding signal estimation apparatus comprising modelling means for applying a predetermined non-linearity to a mixed signal comprising a modulated analog signal and a modulated digital signal.

Such an application of a predetermined non-linearity to a signal allows for an estimation of signal degradation / distortion (designated hereinafter simply as "distortion") that may occur *e.g*. during amplification and transmission of the signal, *i.e.* models signal distortion before it occurs, thus allowing it to be compensated. This technique is particularly useful in the context of a simulcast broadcasting system where signal distortion often arises, both in pre-processing steps and during amplification, in the form of undesirable crosstalk and reduced fidelity. Advantageously, the modulated analog signal and/or the modulated digital signal will be any one of the specific such signals described herein.

Hereinafter, reference will often be made solely to a method although the invention undeniably applies equally to a computer program product appropriately designed, as known in the art, for effecting such steps or to an apparatus comprising equivalent means, i.e. appropriate means configured and adapted for effecting the named steps or results of the described method.

Preferably, the method for signal estimation comprises modulating a digital input signal to an upper or lower sideband of a predetermined carrier. Similarly, the method for signal estimation preferably comprises modulating an analog input signal to an upper or lower sideband of a predetermined carrier. Advantageously, the analog and digital signals are modulated to separate sidebands of the same predetermined carrier and/or are mixed to obtain a mixed signal.

The provision of such modulation allows various types of broadcasting signals to be assessed and is particular adept at simulating an analog / digital simulcast signal.

Advantageously, the method for signal estimation comprises demodulating a signal based on its envelope.

The information contained in an amplitude modulated (AM) signal is typically encoded in the shape of the modulated signal's envelope. By providing for envelope demodulation, the method of the invention can estimate the signal that would be obtained *e.g.* by a signal recipient such as a radio listener using a household radio apparatus for demodulation. Knowledge of an approximately true signal as would be received by a radio listener *e.g.* of an analog / digital simulcast broadcast allows for pre-transmission adjustment of the simulcast signal so as to increase its fidelity upon demodulation by a recipient.

Preferably, the method for signal estimation comprises mixing the predetermined carrier with upper and lower sideband signals, especially with an analog signal modulated to one of said sidebands and a digital signal modulated to the other of said sidebands.

As discussed in EP 1 276 257, an analog / digital simulcast broadcast signal may comprise a digital transmission signal modulated to one sideband of carrier of a transmission channel and a correction signal modulated to the other sideband of the carrier, the correction signal being determined such that envelope demodulation of the transmission channel represents a desired analog transmission signal. By providing the aforementioned mixing, such a simulcast signal can be particularly well simulated.

Preferably, the method for signal estimation comprises equalization, *i.e.* may encompass effecting a predetermined amplification, attenuation and/or phase shift of a signal input thereto as a function of its frequency. The equalization can be carried out prior or subsequent to application of the predetermined non-linearity.

Equalization is a well-known technique for compensating non-linearities in a system transfer function *e.g.* of an amplifier or transmitter, yet itself is a source of signal distortion. Incorporation of equalization into a method for signal estimation allows more precise simulation of a signal that has passed through a system including equalization.

Preferably, the equalization comprises iterative equalization.

The inventors of the present invention have found that iterative equalization exhibits characteristics that highly suit it for application to the field of analog / digital simulcast broadcasting and to signal estimation in a similar context. In particular, in the case of transfer function compensation, it does not require *a priori* knowledge of the transfer function to be compensated in order to yield meaningful results.

Preferably, the method for signal estimation comprises applying a delay to a signal, in particular applying a delay to an analog reference signal so as to obtain a delayed analog reference signal.

Complex signal estimation, *e.g.* signal estimation including simulation of a non-linear system transfer function, can often not be completed in real time without employing unduly costly, specialized circuitry. In some cases, real time signal estimation cannot be achieved at all given the current state of technology. This invariably leads to a signal lag along an estimation path comprising the estimation steps or estimation circuitry.

If an output of the estimation path is to be processed in proper synchronization with an output of a parallel path having a different path lag, the signal of the faster path can be delay so as to reestablish synchronization.

The inventors of the present invention have discovered that, in a simulcast broadcast signal, the analog portion of that signal is particularly susceptible to distortion. A comparison of an estimation of the analog signal that will be broadcast *vis-à-vis* the desired analog signal as a reference signal is indicative of the distortion that may occur and may thus be useful in adapting the broadcast signal prior to broadcast thereof so as to minimize distortion.

The invention may constitute a method for signal deviation estimation. In this respect, the method of the invention may comprise calculating a difference between an estimation signal and a reference signal.

In the context of the present invention, an estimation signal is an output signal of an estimation path. As discussed *inter alia* above, an estimation path may comprise, for example, applying a non-linearity, equalization, modulation, demodulation, etc. Any signal may serve as input to the estimation path. Preferably, however, a signal to be broadcasted, in particular an analog signal to be broadcasted, will serve as input to the estimation path. In an iterative arrangement, the input signal may be refined from iteration stage to iteration stage, e.g. based on the result of one or more previous signal estimations.

Assuming a relationship between the reference signal and the signal input to the estimation path is known, the difference between an estimation signal and a reference signal is indicative of the distortion that the input signal has undergone along the estimation path. If the estimation path is designed so as to reflect a true processing path, said difference will be indicative of changes the input signal will undergo if subject to said true processing path.

In a particularly advantageous embodiment, the signal input to the estimation path and the reference signal are identical. As discussed above, the reference signal may be delayed to compensate for lag in the estimation path.

The invention may constitute a method of signal pre-transmission preparation. Accordingly, the method of the invention preferably comprises one or more of the following steps:
- applying a delay to the analog input signal, in particular to obtain a delayed analog input signal,
- weighting an estimated deviation signal,
- summing the (weighted) deviation signal with the (delayed) analog input signal, in particular to obtain a correction signal, and/or
- applying a delay to the digital input signal, in particular to obtain a delayed digital signal.

The application of a delay to the analog input signal or the digital signal is especially advantageous for (re-)synchronizing the signal with other signals that may have travelled a different processing / transmission path and may have consequently been subject to a different processing / propagation delay. This is of particular value when several signals are to be distinctly processed yet synchronously broadcast.

Weighting of the estimated deviation signal allows more or less significance to be given to the estimated deviation signal e.g. for a subsequent processing step. If appropriate, a weighting of one can be chosen. Preferably, however, the weighting is chosen to be different from one and/or negative.

As noted above, the deviation signal is preferably a derivative of the analog input signal. Summing or, in the case of a prior negative weighting, subtracting the deviation signal with / from the analog input signal yields a result indicative of the changes that the processing resulting in the deviation signal effects on the analog input signal. Such a result is useful as a correction signal e.g. for broadcast as part of a simulcast broadcast or for employment in a simulcast broadcasting system, in particular a simulcast broadcast or simulcast broadcasting system as taught in EP 1 276 257, cited above. *Inter alia*, EP 1 276 257 teaches an AM simulcast broadcast signal combining a digital transmission signal and an analog transmission signal into one transmission channel, wherein the digital transmission signal is modulated to one sideband of a carrier of the transmission channel and a correcting signal is modulated to the other sideband of the carrier of the transmission channel, which correcting signal is determined so that the envelope demodulation of the transmission channel represents the analog transmission signal.

The method of the invention, in particular the steps related to the obtaining of a correction signal or to pre-transmission processing of a signal, may be reiterated. This can lead to further refinement of the processed signals.

Preferably, each reiteration of method receives, as its "analog input signal," the correction signal of an immediately preceding iteration of the method. In this manner, a correction signal associated with the current iteration can be derived from the correction signal of the immediately preceding iteration rather than the original analog input signal. Such a configuration can be employed for iterative refinement of the correction signal.

Preferably, each reiteration of the method receives, as the analog reference signal, the delayed analog reference signal of the immediately preceding iteration. Such a configuration provides each iteration with a consistent reference signal e.g. with which to compare an estimation signal associated with the current iteration. Appropriate delay of the analog reference signal during each iteration allows for a simple, modular hardware design or a design wherein the respective signals repeatedly pass through a single processing unit.

Preferably, each reiteration of the method receives, as the digital input signal, the delayed digital signal of the immediately preceding iteration. As above, this too allows for a simple design.

Preferably, the method comprises modulating the delayed digital signal of a last iteration of the method to the upper or lower sideband of a predetermined carrier. Preferably, the method comprises modulating the correction signal of the last iteration to the other of said upper or lower sidebands. Preferably, the method comprises processing the modulated delayed digital signal and/or the modulated correction signal, including mixing a signal corresponding to the predetermined carrier with the upper and/or lower sideband signal(s), so as to obtain a pre-transmission signal, i.e. a signal pre-processed for transmission. Such processing preferably comprises equalization identical to an equalization during the processing of a mixed signal, i.e. during signal estimation, in one or more iterations of the method.

Such mixed / modulated signals are useful as signals for transmission e.g. for broadcast as part of a simulcast broadcast or for employment in a simulcast broadcasting system, in particular a simulcast broadcast or simulcast broadcasting system as taught in EP 1 276 257, cited above.

The provision of equalization at a stage associated with transmission identical to equalization carried out during signal estimation allows the signal estimation to more realistically simulate the transmission process. Thus, the equalization of any iteration will preferably be identical to the equalization at the transmission stage. In itself, equalization at the transmission stage allows for predistortion of the transmission signal so as to compensate for non-linearities in the amplifier.

The invention may constitute a method for broadcasting, in particular simulcast broadcasting. Accordingly, the method of the invention preferably comprises transmitting any of the aforementioned signals.

### BRIEF DESCRIPTION OF THE DRAWINGS

The novel features of the invention, as well as the invention itself, both as to its structure and its operation will be best understood from the accompanying figures, taken in conjunction with the accompanying description.
- **Fig. 1**: shows the schematic spectrum of a simulcast signal in accordance with the teachings of EP 1 276 257.
- **Fig. 2**: demonstrates a signal flow in a method / apparatus / program product in accordance with a first preferred embodiment of the invention suitable for generating a broadcasting signal.
- **Fig. 3**: demonstrates a signal flow in a method / apparatus / program product in accordance with a second preferred embodiment of the invention suitable for generating a broadcasting signal.
- **Fig. 4**: demonstrates a signal flow in a method / apparatus / program product in accordance with a third preferred embodiment of the invention suitable for generating a broadcasting signal.

### DESCRIPTION OF THE PREFERRED EMBODIMENTS

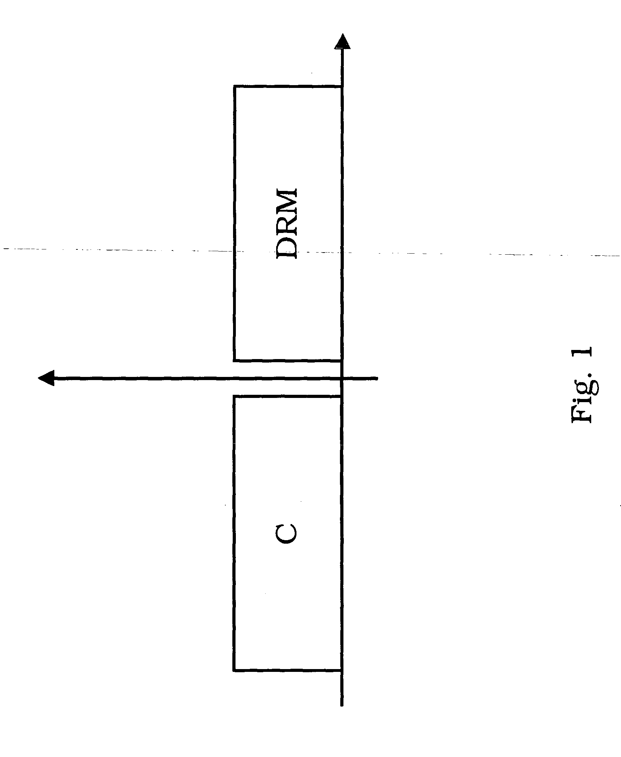

Fig. 1 schematically illustrates the spectrum of a simulcast signal in accordance with the teachings of EP 1 276 257, *i.e.* an AM simulcast broadcast signal combining a digital transmission signal and an analog transmission signal into one transmission channel, wherein the digital transmission signal is modulated to one sideband of a carrier of the transmission channel and a correcting signal is modulated to the other sideband of the carrier of the transmission channel, which correcting signal is determined so that the envelope demodulation of the transmission channel represents the analog transmission signal. In DRM (Digital Radio Mondeal) broadcasting, a digital and an analog signal have to be combined in one channel. To avoid distortions of the digital system, the EP 1 276 257 suggests transmitting a digitally modulated signal in one sideband of the channel. This allows distortion-free demodulation of the digitally modulated signal in the receiver. As stated above, the present invention is advantageously applicable to the broadcast of such signals, in particular to the generation of an appropriate correction signal.

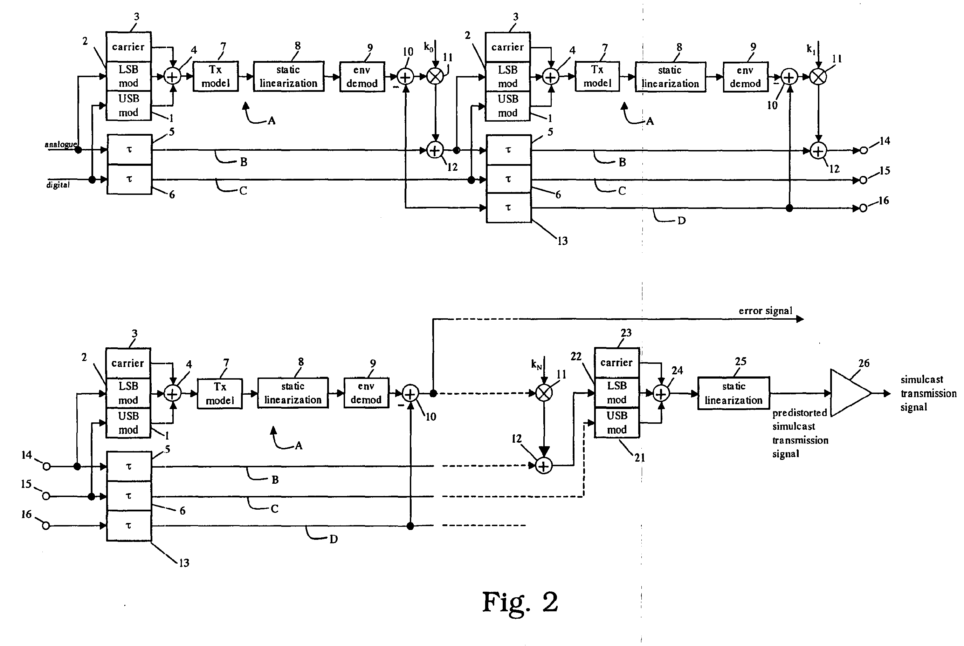

Fig. 2 schematically illustrates a signal flow in a method / apparatus / program product in accordance with a first preferred embodiment of the invention suitable for generating a broadcasting signal. The signal flow comprises several (three are explicitly shown) iteration stages for obtaining / refining a correction signal as well as a transmission stage.

Speaking in the nomenclature of an apparatus, each of the iteration stages shown in Fig. 2 comprises an upper sideband modulation unit 1, a lower sideband modulation unit 2, a carrier signal generation unit 3, a mixer 4, an analog input signal delay unit 5, a digital input signal delay unit 6, a transmitter modelling unit 7, an optional static linearization unit 8 or primary equalizer 8, if applicable an envelope demodulator 9, a summing unit 10, a weighting unit 11 and a summing unit 12. The second, third and higher iteration stages - i.e. every higher iteration stage - in the series comprise an analog reference signal delay unit 13 and/or - if applicable - a digital reference signal delay unit 18. The transmission stage - in particular after iteration stages 10, ..., IN, IN+1 - is likewise shown as comprising an upper sideband modulation unit 21, a lower sideband modulation unit 22 and a carrier signal generation unit 23. It is moreover shown as comprising a mixer 24, and an optional static linearization unit 25 or equalizer 25 and an amplifier 26 corresponding to a transmitter. Reference points 14, 15, 16, and 17 solely indicate that the Figure is to be viewed as integral despite its division into two entities for the sake of easier viewing.

Fig. 2 also shows four signal paths A, B, C and D that respective signals may travel. Signal path A extends through lower sideband modulation unit 2, transmitter modelling unit 7, static linearization unit 8 and envelope demodulator 9. Signal path B encompasses analog input signal delay unit 5. and signal path C encompasses digital input signal delay unit 6. Signal path D is only found in the second, third, and higher iteration stages and encompasses analog reference signal delay unit 13. Signal path B is an extension of signal path B of the first iteration.

The illustrated signal flow is as follows. An analog input signal is fed to both lower sideband modulation unit 2 and analog input signal delay unit 5. A digital input signal is fed to both upper sideband modulation unit 1 and digital input signal delay unit 6. The choice as to which signal should be modulated to which sideband is arbitrary. Analog input signal delay unit 5 and digital input signal delay unit 6 subject the respective signals input thereto to a respective, predetermined delay τ. The delay τ of each signal delay unit 5, 6 is shown as being identical. Typically, however, their respective delays will differ.

Carrier signal generation unit 3 generates a predetermined carrier signal. Lower sideband modulation unit 2 modulates the analog input signal to the lower sideband of the carrier signal, and upper sideband modulation unit 1 modulates the digital input signal to the upper sideband of the carrier signal. The resultant three signals are mixed by mixer 4 and fed to transmitter modelling unit 7, the output of which is processed by static linearization unit 8.

In the illustrated, exemplary embodiment, transmitter modelling unit 7 applies a predetermined non-linearity to a signal passing therethrough. Preferably, the predetermined non-linearity approximates the system transfer function H(t, f) of transmitter 26. Static linearization unit 8 is preferably designed so as to apply, to the best degree possible in a static implementation, the inverse function of the transmitter model transfer function, i.e. 1 / H(t, f), to a signal passing therethrough. Static linearization unit 8 may precede or follow (as shown) transmitter modelling unit 7 in the signal path. As an optional feature of this embodiment of the invention, it may also be left out altogether.

The output of the static linearization unit 8 is fed to envelope demodulator 9, which effectively restores the analog input signal, via envelope demodulation, from the modulated, mixed, distorted and un distorted signal fed thereto, albeit with the residual error inherent to such complex, non-linear encoding / decoding processes. It is this residual error that the invention, *inter alia*, seeks to isolate so as to be in a position to effect appropriate compensation thereof.

The restored analog signal output from envelope demodulator 9 is fed, as a negative input, to summing unit 10 where it is thus subtracted from the appropriately delayed, analog input signal communicated from analog input signal delay unit 5 to a positive input of summing unit 10. Assuming that analog input signal delay unit 5 subjects the analog input signal to a delay chosen so as to restore synchronization between the analog input signal that has travelled signal path B to the analog input signal that has travelled signal path A at their point of summing in summing unit 10, the output thereof will equal a residual error inherent to the processing encompassed within signal path A. This residual error is thus indicative of an error that would arise if the analog input signal were to be broadcast and received, *i.e.* coded, transmitted and decoded, under the conditions simulated by signal path A.

The residual error signal output from summing unit 10 is input to weighting unit 11. where it is weighted by a respective weighting coefficient k₀, k₁ ... k_{N} of the respective iteration stage and output as a correction signal.

Summing unit 12 sums the correction signal output by weighting unit 11 and the delayed analog input signal output from analog input signal delay unit 5 and feds the summed signal result, *i.e.* a corrected analog input signal, to the next iteration / transmission stage as the analog input signal thereof. The residual error signal output by summing unit 10 of the final iteration stage is output as a error signal that is indicative of the maximal residual error comprised in the corrected analog input signal obtained in the final iteration stage.

Digital input signal delay unit 6 delays the digital input signal input thereto, preferably such that its output is in synch with the summed signal output by summing unit 12, and feds the delayed digital input signal to the next iteration / transmission stage as the digital input signal thereof.

A further branch of signal path B feds the delayed analog input signal from analog input signal delay unit 5 to the next iteration / transmission stage as the analog reference signal thereof, *i.e.* preferably to analog reference signal delay unit 13 thereof. In the iteration stages subsequent to the first iteration stage, summing unit 10 receives the analog reference signal delayed by analog reference signal delay unit 13 as a positive input. In this manner, summing unit 10 consistently outputs a residual error signal with reference to the original analog input signal whose broadcast and distortion-free reception is desired. Consequently, the delay τ of each analog reference signal delay unit 13 is preferably chosen to delay the analog reference signal input thereto such that the analog input signal that has travelled signal paths B and D is in synch with the analog input signal that has travelled signal paths A at their point of summing in summing unit 10.

As in the iteration stages, carrier signal generation unit 23 of the transmitter stage generates a predetermined carrier signal. The corrected analog input signal output by summing unit 12 of the final iteration stage is fed to the lower sideband modulation unit 22 of the transmitter stage, where it is modulated to the lower sideband of the carrier signal. The delayed digital input signal output by the delay unit 6 of the final iteration stage is fed to the upper sideband modulation unit 21 of the transmitter stage, where it is modulated to the upper sideband of the carrier signal. The resultant three signals are mixed by mixer 24 and fed to static linearization unit 25. The transfer function of static linearization unit 25 that is preferably the inverse function of the transmitter model transfer function, *i.e.* static linearization unit 25 effects predistortion of the signal passing therethrough that counterbalances distortion inherent to the transmission of that signal via transmitter 26.

Static linearization unit 25 of the transmitter stage, like static linearization units 8 of the iteration stages, is an optional feature. As noted above, it is highly advantageous if each of the processing stages is equipped with a static linearization unit and these static linearization units share a common transfer function. Former reduces the total distortion of the system, whereas latter ensures that a corrected analog input signal most appropriate for transmission via the transmitter stage is established by the series of iteration stages.

The output of static linearization unit 25 or mixer 24 (in the case of no static linearization unit 25) is fed to transmitter 26, where it is amplified and broadcast.

In simple cases, the model employed by transmitter modelling unit 7 may be approximated by a system transfer function H(t, f). The model of the transmitter non-linearity thereby assumes that any distortion due to the transmitter 26 is included in the computation of the (residual) error signal. Iterative application of the iteration stage results in a transmission signal, *i.e.* a corrected analog input signal, that has the desired properties in the time and frequency domain at the output of the transmitter 26. For a DRM (Digital Radio Mondeal) transmission system, this can significantly reduce the distortions in-band and out-of-band of the transmission signal.

Optionally, an additional, state of the art transmitter equalizer, also called static linearization, can be included behind or before the transmitter model. This equalizer could, for example, try to statically implement the inverse function of the transmitter model transfer function, *i.e.* 1 /H(t, f). In that case, the iterative algorithm must only correct the residual error, resulting in faster convergence of the iterative system. In case this option is employed, the static linearization should also be performed at the output of the last stage of the encoder, i.e. in the transmission stage. The output of static linearization unit 25 is then the input signal to the actual transmitter non-linearity, *e.g.* the output stage power amplifier.

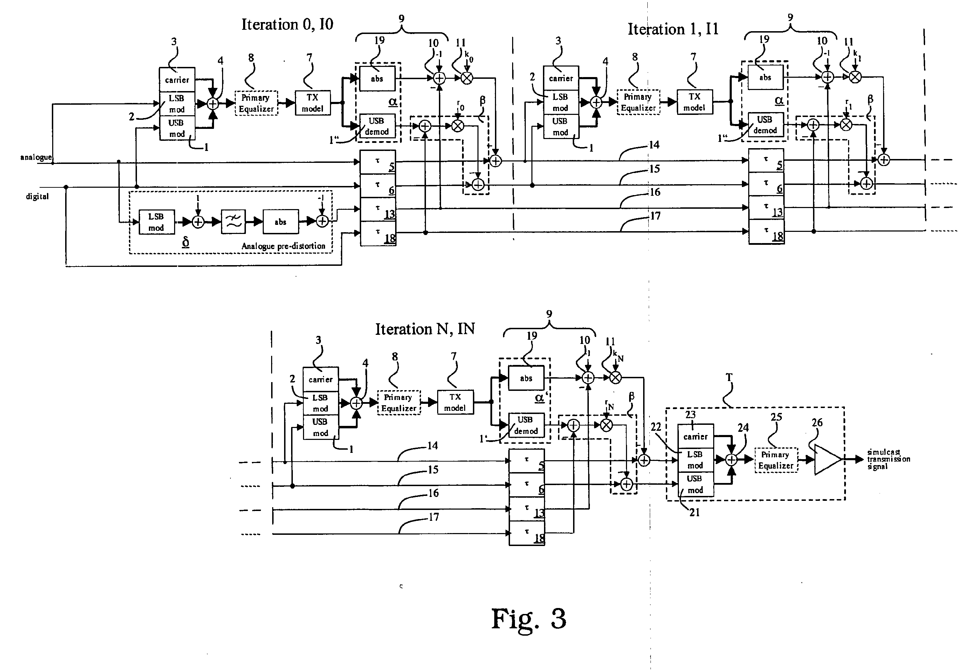

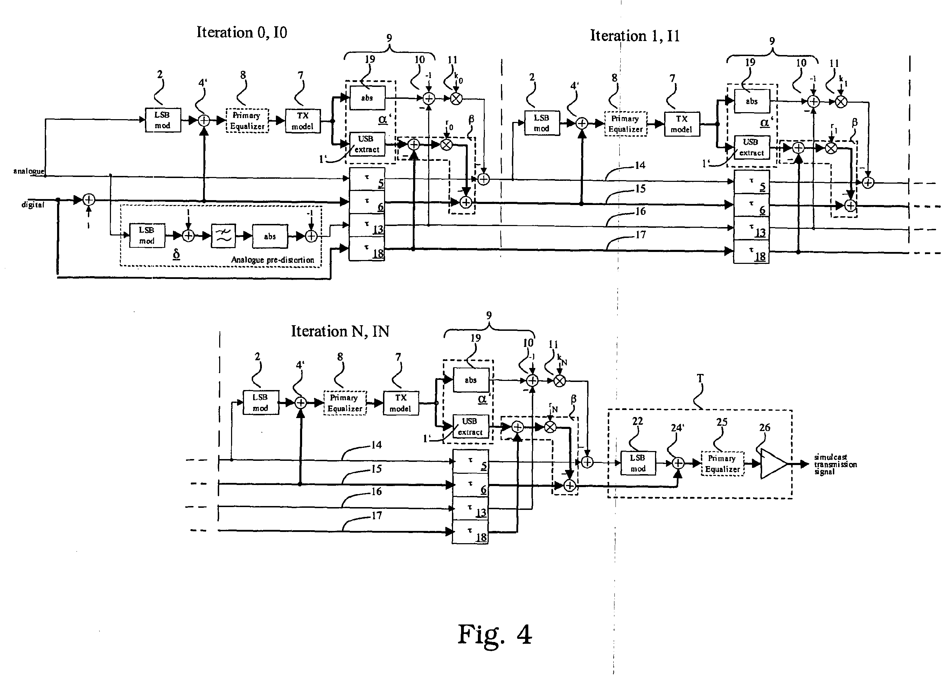

The embodiments according to Figs. 3 and 4 - although comparable to some extent to the arrangement according to Fig. 2 - further comprise a USB extraction or USB demodulation process within th envelope demodulation process 9. Here inter alia the identity of the incoming and leaving signals is checked which is violated if the primary equalizer 8 and the TX or transmission model section 7 generated disturbances. According to the iteration stages 10, ..., IN of the whole processes of Figs. 2, 3, and 4 the complexity of the primary equalizer 8 and/or the TX or transmission model is circumvented or bypassed. The respective analogue pre-distortion therefore yields a demodulated sideband as a reference.

The present invention can also be described according to the following elucidations:

According to one aspect of the present invention a signal estimation apparatus is provided, comprising first modulation means 1 configured and adapted for modulating a digital input signal to an upper or lower sideband of a predetermined carrier, second modulation means 2 configured and adapted for modulating an analog input signal to the other of said upper or lower sidebands, mixing means 4 configured and adapted for mixing at least said upper and lower sideband signals so as to output a mixed signal, first processing means, including modeling means 7 for applying a predetermined non-linearity, configured and adapted for processing said mixed signal so as to output a processed signal, and an envelope demodulator 9 configured and adapted for demodulating said processed signal based on its envelope so as to output an estimation signal.

Said mixing means may be configured and adapted for mixing said predetermined carrier with said upper and lower sideband signals so as to output said mixed signal.

Said first processing means may include equalizer means 8.

Said equalizer means 8 may comprise an iterative equalizer.

According to another aspect of the present invention a signal deviation estimation apparatus is proposed, comprising a signal estimation apparatus according to the present invention, first delay means 5, 13 configured and adapted for applying a delay to an analog reference signal so as to output a delayed analog reference signal, and subtracting means 10 configured and adapted for calculating a difference between said estimation signal and said delayed analog reference signal so as to output an estimated deviation signal.

Said analog reference signal may be said analog input signal.

According to a further aspect of the present invention a signal pre-transmission preparation apparatus is proposed, comprising: a signal deviation estimation apparatus according to the present invention, second delay means 5 configured and adapted for applying a delay to said analog input signal so as to output a delayed analog input signal, weighting and summing means 11, 12 configured and adapted for weighting said estimated deviation signal and summing the result with said delayed analog input signal so as to output a correction signal, and third delay means 6 configured and adapted for applying a delay to said digital input signal so as to output a delayed digital signal.

According to still a further aspect of the present invention a simulcast broadcasting system is provided, comprising: a signal pre-transmission preparation apparatus according to the present invention, third modulation means 21 configured and adapted for modulating said delayed digital signal to said upper or lower sideband of a predetermined carrier, fourth modulation means 22 configured and adapted for modulating said correction signal to said other of said upper or lower sidebands, second processing means, including mixing means 24 for mixing a signal corresponding to said predetermined carrier with said upper and lower sideband signals, configured and adapted for processing said upper and lower sideband signals so as to output a pre-transmission signal, and transmitter means 26 configured and adapted for transmitting said pre-transmission signal.

Said simulcast broadcasting system according may comprise one or more additional signal pre-transmission preparation apparatuses according to the present invention, wherein said additional signal pre-transmission preparation apparatuses are connected in series between said signal pre-transmission preparation apparatus and said third and fourth modulation means, each of said additional signal pre-transmission preparation apparatuses receives, as said analog input signal, said correction signal of an immediately preceding signal pre-transmission preparation apparatus in said series connection, each of said additional signal pre-transmission preparation apparatuses receives, as said analog reference signal, said delayed analog reference signal of said immediately preceding signal pre-transmission preparation apparatus, and each of said signal pre-transmission preparation apparatuses receives, as said digital input signal, said delayed digital signal of said immediately preceding signal pre-transmission preparation apparatus.

Said signal pre-transmission preparation apparatus constitutes part of an iterative loop may be configured and adapted to have the effect of one or more additional signal pre-transmission preparation apparatuses connected in series between said signal pre-transmission preparation apparatus and said third and fourth modulation means.

Each of said additional signal pre-transmission preparation apparatuses may receive, as said analog input signal, said correction signal of an immediately preceding signal pre-transmission preparation apparatus in said series connection.

Each of said additional signal pre-transmission preparation apparatuses receives, as said analog reference signal, said delayed analog reference signal of said immediately preceding signal pre-transmission preparation apparatus.

Each of said signal pre-transmission preparation apparatuses may receive as said digital input signal, said delayed digital signal of said immediately preceding signal pre-transmission preparation apparatus.

Said second processing means may comprise equalizer means identical to an equalizer means in one or more first processing means thereof.

As an additional aspect of the present invention a method for signal estimation is provided, comprising the steps of modulating a digital input signal to an upper or lower sideband of a predetermined carrier, modulating an analog input signal to the other of said upper or lower sidebands, mixing at least said upper and lower sideband signals so as to obtain a mixed signal, processing said mixed signal, including applying a predetermined non-linearity, so as to obtain a processed signal, and demodulating said processed signal based on its envelope so as to obtain an estimation signal.

Said mixing step may comprise mixing said predetermined carrier with said upper and lower sideband signals so as to obtain said mixed signal.

Said processing step may include equalization.

Said equalization may comprise iterative equalization.

As an additional aspect of the present invention a method for signal deviation estimation is provided, comprising a method for signal estimation signal estimation according to the present invention as well as the steps of applying a delay to an analog reference signal so as to obtain a delayed analog reference signal, and calculating a difference between said estimation signal and said delayed analog reference signal so as to obtain an estimated deviation signal.

Said analog reference signal may be said analog input signal.

As a further aspect of the present invention a method for signal pre-transmission preparation is provided, comprising a method for signal deviation estimation according to the present invention as well as the steps of applying a delay to said analog input signal so as to obtain a delayed analog input signal, weighting said estimated deviation signal and summing the result with said delayed analog input signal so as to obtain a correction signal, and applying a delay to said digital input signal so as to obtain a delayed digital signal.

The method may further comprise one or more re-iterations of the method for signal pre-transmission preparation according to the present invention, wherein each reiteration of said signal pre-transmission preparation method receives, as said analog input signal, said correction signal of an immediately preceding iteration of said method for signal pre-transmission preparation, each reiteration of said signal pre-transmission preparation method receives, as said analog reference signal, said delayed analog reference signal of said immediately preceding iteration, and each reiteration of said signal pre-transmission preparation method receives, as said digital input signal, said delayed digital signal of said immediately preceding iteration.

In addition, in accordance to the present invention a method for simulcast broadcasting is provided, comprising a method for signal pre-transmission preparation according to the present invention as well as the steps of modulating said delayed digital signal of a last iteration of said method for signal pre-transmission preparation to said upper or lower sideband of a predetermined carrier, modulating said correction signal of said last iteration to said other of said upper or lower sidebands, processing said modulated delayed digital signal and said modulated correction signal, including mixing a signal corresponding to said predetermined carrier with said upper and lower sideband signals, so as to obtain a pre-transmission signal, and transmitting said pre-transmission signal.

Said step of processing said modulated delayed digital signal and said modulated correction signal may comprise equalization identical to said equalization in said processing of said mixed signal in one or more iterations of said method for signal pre-transmission preparation.

According to a further aspect of the present invention a computer program product is provided, comprising computer program means for carrying out the method steps according to the present invention when executed on a computer, digital signal processor or the like.

Since both tasks, linearization of the transmitter as well as simulcast encoding, are highly non-linear operations, joint optimization yields better results, e.g. less distortion at the output of the transmitter.

While the preferred and alternative embodiments of the present invention have been disclosed and described in detail herein, it will be apparent to those skilled in the art that various changes may be made to the configuration, operation and form of the invention without departing from the spirit and scope thereof. In particular, it is noted that the respective features of the invention, even those disclosed solely in combination with other features of the invention, may be combined in any configuration excepting those readily apparent to the person skilled in the art as nonsensical. Likewise, use of the singular and plural is solely indicative of a preference and is not to be interpreted as limiting. Except where the contrary is explicitly noted, the plural may be replaced by the singular and vice-versa.

## Claims

1. Signal estimation apparatus, comprising:
- first modulation means (1) configured and adapted for modulating a digital input signal to an upper or lower sideband of a predetermined carrier,
- second modulation means (2) configured and adapted for modulating an analog input signal to the other of said upper or lower sidebands,
- mixing means (4) configured and adapted for mixing at least said upper and lower sideband signals so as to output a mixed signal,
- first processing means, including modelling means (7) for applying a predetermined non-linearity, configured and adapted for processing said mixed signal so as to output a processed signal, and
- an envelope demodulator (9) configured and adapted for demodulating said processed signal based on its envelope so as to output an estimation signal.

2. Signal estimation apparatus according to claim 1,
wherein said mixing means is configured and adapted for mixing said predetermined carrier with said upper and lower sideband signals so as to output said mixed signal.

3. Signal estimation apparatus according to any one of the preceding claims 1 or 2,
wherein said first processing means includes equalizer means (8).

4. Signal estimation apparatus according to claim 4,
wherein said equalizer means comprises an iterative equalizer.

5. Signal deviation estimation apparatus, comprising:
- a signal estimation apparatus of any of the preceding claims,
- first delay means (5, 13) configured and adapted for applying a delay to an analog reference signal so as to output a delayed analog reference signal, and
- subtracting means (10) configured and adapted for calculating a difference between said estimation signal and said delayed analog reference signal so as to output an estimated deviation signal.

6. Signal deviation estimation apparatus according to claim 5,
wherein:
said analog reference signal is said analog input signal.

7. Signal pre-transmission preparation apparatus, comprising:
- a signal deviation estimation apparatus according to any one of the claims 5 or 6,
- second delay means (5) configured and adapted for applying a delay to said analog input signal so as to output a delayed analog input signal,
- weighting and summing means (11, 12) configured and adapted for weighting said estimated deviation signal and summing the result with said delayed analog input signal so as to output a correction signal, and
- third delay means (6) configured and adapted for applying a delay to said digital input signal so as to output a delayed digital signal.

8. Simulcast broadcasting system, comprising:
- a signal pre-transmission preparation apparatus according to claim 7,
- third modulation means (21) configured and adapted for modulating said delayed digital signal to said upper or lower sideband of a predetermined carrier,
- fourth modulation means (22) configured and adapted for modulating said correction signal to said other of said upper or lower sidebands,
- second processing means, including mixing means (24) for mixing a signal corresponding to said predetermined carrier with said upper and lower sideband signals, configured and adapted for processing said upper and lower sideband signals so as to output a pre-transmission signal, and
- transmitter means (26) configured and adapted for transmitting said pre-transmission signal.

9. Simulcast broadcasting system according to claim 8, comprising:
- one or more additional signal pre-transmission preparation apparatuses in accordance with claim 7, wherein
- said additional signal pre-transmission preparation apparatuses are connected in series between said signal pre-transmission preparation apparatus and said third and fourth modulation means,
- each of said additional signal pre-transmission preparation apparatuses receives, as said analog input signal, said correction signal of an immediately preceding signal pre-transmission preparation apparatus in said series connection,
- each of said additional signal pre-transmission preparation apparatuses receives, as said analog reference signal, said delayed analog reference signal of said immediately preceding signal pre-transmission preparation apparatus, and
- each of said signal pre-transmission preparation apparatuses receives, as said digital input signal, said delayed digital signal of said immediately preceding signal pre-transmission preparation apparatus.

10. Simulcast broadcasting system of claim 8,
wherein:
- said signal pre-transmission preparation apparatus constitutes part of an iterative loop configured and adapted to have the effect of one or more additional signal pre-transmission preparation apparatuses connected in series between said signal pre-transmission preparation apparatus and said third and fourth modulation means,
- each of said additional signal pre-transmission preparation apparatuses receives, as said analog input signal, said correction signal of an immediately preceding signal pre-transmission preparation apparatus in said series connection,
- each of said additional signal pre-transmission preparation apparatuses receives, as said analog reference signal, said delayed analog reference signal of said immediately preceding signal pre-transmission preparation apparatus, and
- each of said signal pre-transmission preparation apparatuses receives, as said digital input signal, said delayed digital signal of said immediately preceding signal pre-transmission preparation apparatus.

11. Simulcast broadcasting system according to any one of the preceding claims 8 to 10,
wherein said second processing means comprises equalizer means identical to an equalizer means in one or more first processing means thereof.

12. Method for signal estimation, comprising the steps of:
- modulating a digital input signal to an upper or lower sideband of a predetermined carrier,
- modulating an analog input signal to the other of said upper or lower sidebands,
- mixing at least said upper and lower sideband signals so as to obtain a mixed signal,
- processing said mixed signal, including applying a predetermined non-linearity, so as to obtain a processed signal, and
- demodulating said processed signal based on its envelope so as to obtain an estimation signal.

13. Method for signal estimation according to claim 12,
wherein said mixing step comprises mixing said predetermined carrier with said upper and lower sideband signals so as to obtain said mixed signal.

14. Method for signal estimation according to any one of the preceding claims 12 or 13,
wherein said processing step includes equalization.

15. Method for signal estimation according to claim 14,
wherein said equalization comprises iterative equalization.

16. Method for signal deviation estimation,
comprising a method for signal estimation signal estimation according to any one of the preceding claims 12-15 as well as the steps of:
- applying a delay to an analog reference signal so as to obtain a delayed analog reference signal, and
- calculating a difference between said estimation signal and said delayed analog reference signal so as to obtain an estimated deviation signal.

17. Method for signal deviation estimation of claim 16,
wherein said analog reference signal is said analog input signal.

18. Method for signal pre-transmission preparation,
comprising a method for signal deviation estimation according to any one of the preceding claims 16 or 17 as well as the steps of:
- applying a delay to said analog input signal so as to obtain a delayed analog input signal,
- weighting said estimated deviation signal and summing the result with said delayed analog input signal so as to obtain a correction signal, and
- applying a delay to said digital input signal so as to obtain a delayed digital signal.

19. Method for signal pre-transmission preparation according to claim 18,
comprising one or more re-iterations of the method for signal pre-transmission preparation according to claim 18,
wherein:
- each reiteration of said signal pre-transmission preparation method receives, as said analog input signal, said correction signal of an immediately preceding iteration of said method for signal pre-transmission preparation,
- each reiteration of said signal pre-transmission preparation method receives, as said analog reference signal, said delayed analog reference signal of said immediately preceding iteration, and
- each reiteration of said signal pre-transmission preparation method receives, as said digital input signal, said delayed digital signal of said immediately preceding iteration.

20. Method for simulcast broadcasting,
comprising a method for signal pre-transmission preparation according to any one of the preceding claims 18 or 19 as well as the steps of:
- modulating said delayed digital signal of a last iteration of said method for signal pre-transmission preparation to said upper or lower sideband of a predetermined carrier,
- modulating said correction signal of said last iteration to said other of said upper or lower sidebands,
- processing said modulated delayed digital signal and said modulated correction signal, including mixing a signal corresponding to said predetermined carrier with said upper and lower sideband signals, so as to obtain a pre-transmission signal, and
- transmitting said pre-transmission signal.

21. Method for simulcast broadcasting of claim 20,
wherein said step of processing said modulated delayed digital signal and said modulated correction signal comprises equalization identical to said equalization in said processing of said mixed signal in one or more iterations of said method for signal pre-transmission preparation.

22. Computer program product,
comprising computer program means for carrying out the method steps according to any one of the preceding claims 12 to 21 when executed on a computer, digital signal processor or the like.
